# EUROPEAN PATENT APPLICATION

(11) **EP 0 905 772 A2**
(43) Date of publication of application: **31.03.1999**
(21) Application number: 98116300.9
(22) Date of filing: 28.08.1998
(51) Int. Cl.: H01L 21/8242, H01L 27/108

(54) **Trench capacitor DRAM cell and method of making the same**

(30) Priority: 30.09.1997 US 940529
(71) Applicant: SIEMENS AKTIENGESELLSCHAFT, 80333 München (DE)
(72) Inventor: Scheller, Gerd, 8800 Thaiwil (CH); Gall, Martin, South Burlington, VT 05403 (US)
(74) Representative: Patentanwälte Westphal, Mussgnug & Partner

(57) **Abstract**

A memory cell, which includes a transistor and a capacitor, for use in a DRAM uses a silicon-filled vertical trench as the capacitor and a vertical transistor superposed over the vertical trench in a silicon chip. An epitaxial layer is formed at the top of the fill in the trench to impart seed information to the primarily polysilicon silicon fill in the trench. A polysilicon layer is deposited over the top surface of the chip, is apertured over the top of the trench, and has its sidewalls oxidized. The opening is then refilled with epitaxial silicon in which there is created in operation an inversion layer that serves as the channel of the transistor, and the deposited polysilicon layer serves as the word line. Another silicon layer is deposited over the epitaxial layer to serve as the bit line. The source/drain regions of the transistor are formed at the merger of the deposited layer with the fill in the trench and the merger with the polysilicon layer that serves as the bit line.

## Description

### Field of the Invention

This invention relates to memory cells for use in a dynamic random access memory (DRAM) and, more particularly, to a memory cell that uses a dielectrically-filled vertical trench as a storage node and a vertical transistor as a switch located over the trench.

### Background of the Invention

DRAMS have become among the most important of the integrated circuit devices and are the source of continuing research and development which, in particular, aims to increase their storage capacity and writing and reading speeds. This has necessitated the use of smaller and more closely spaced memory cells for use in the memory arrays. Of increasing significance are memory cells in which the storage node is provided by a polysilicon-filled trench in a silicon chip and the switching transistor is a vertical transistor located in the chip over the trench. It is known that a DRAM that uses a MOSFET as the switching transistor. The two output current terminals of the transistor alternate between source and drain roles as the storage node is charged and discharged. As such, each of these terminals can be described as a source/drain and a drain/source, as is appropriate for the particular role. For purposes of discussion, these terminals are simply referred to as a source/drain. The vertical transistor is located over the storage node in a manner which renders the surface area of the chip used by the cell to be essentially the same as that used by the vertical trench. Ideally, a cell using a vertical transistor can provide higher packing densities than a cell that uses a horizontal switching transistor that is positioned adjacent to the trench that provides the storage node. One type of a vertical transistor over a vertical trench cell is described in U.S. Patent Application Serial No. 08/770,962, filed on December 20, 1996, in which Norbert Arnold is the inventor and the assignee is the same as that of the present application.

### Summary of the Invention

A memory cell of the present invention has a unique structure fabricated by a novel process. In one embodiment, a semiconductor chip is first provided with a vertical trench to be used in forming the storage capacitor of the cell. After the trench is made, the dielectric of the capacitor is formed by coating its walls with a dielectric material. The storage node of the capacitor is provided by a doped polysilicon fill of the trench. The top portion of the trench is provided with essentially monocrystalline silicon, suitable for forming one source/drain of the vertical transistor. An additional silicon layer, intermediately placed between two dielectric layers, is subsequently deposited over the chip. The three layers are apertured in the region over the trench to expose the top of the fill. Typically, this layer is polysilicon. The walls of the additional polysilicon layer that were exposed in the aperturing operation are oxidized to form the gate dielectric of the transistor. The aperture is then filled with silicon that is appropriate to form the intermediate layer of the transistor in which there is to be created during operation the inversion layer that forms the channel between the source/drain regions of the transistor. Ultimately an additional silicon layer is formed that will form with this intermediate layer the second source/drain region of the transistor. A bit line connection is made to this last-mentioned layer, and a word line is provided by the apertured polysilicon layer.

Another embodiment of the present invention is directed to a memory cell that is for use in a memory array of rows and columns of memory cells within a monocrystalline bulk portion of a silicon chip and that is addressed by word lines and bit lines. The memory cell comprises a capacitor, a vertical transistor, a word line, and a bit line. The capacitor comprises a vertical trench filled with silicon and having a layer of dielectric along its wall that isolates the silicon fill from the bulk portion of the chip. The vertical transistor is superposed over the trench and has a first source/drain merged with the silicon at the top of the trench, an intermediate silicon layer that is merged with the silicon fill at the top of the trench to form the first source/drain region, and in which an inversion layer is to be created to form a conductive channel, a second source/drain region overlying the intermediate silicon layer, a gate dielectric layer surrounding the intermediate silicon layer, and a gate surrounding the gate dielectric layer and extending along the surface of the chip and dielectrically insulated therefrom and being coupled to a word line. The bit line is in electrical contact with the second source/drain and otherwise extends over the surface of the trench and is electrically insulated from the word line and from the chip.

In another embodiment, the invention is a novel process of fabricating the cell that includes imparting seed information to the polysilicon deposited in the trench. This seed information makes it possible to provide a semiconductor intermediate layer wherein the channel of the transistor can be created.

In another embodiment, the present invention is directed to a process for making a memory cell. The process comprises the steps of forming a trench in a semiconductor chip of one conductivity type; forming a dielectric layer over the walls of the trench; filling the trench with polysilicon of a conductivity type opposite that of the chip; growing an epitaxial silicon layer over the surface of the chip of sufficient thickness for forming over the top of the trench a layer of essentially monocrystalline silicon of a conductivity that is opposite that of the chip for serving as a first source/drain; forming a first dielectric layer over the surface of the chip; forming a polysilicon layer of the conductivity type opposite that of the chip over the surface of the first dielectric layer; forming a second dielectric layer over the surface of said polysilicon layer; etching an opening through the first and second dielectric layers and said polysilicon layer to bare the essentially monocrystalline silicon over the top of the trench; forming a silicon oxide layer selectively along the sidewall of the opening in the polysilicon layer; growing monocrystalline silicon of the one conductivity type in the opening for forming an intermediate layer in which there will be formed the channel of a vertical transistor in which the silicon oxide layer over the sidewall of said polysilicon layer of the opening serves as the gate dielectric; and depositing a conductive layer of the opposite conductivity type over the top surface of the chip that contacts the intermediate silicon layer for serving as a second source/drain and bit line of the cell.

The invention will be better understood from the following more detailed description taken in conjunction with the accompanying drawing.

### Brief Description of the Drawings

FIG. 1 is an electrical circuit schematic of a standard memory cell that includes a transistor and a capacitor of the kind used in DRAMS;
FIG. 2 is a cross section of a portion of a silicon chip including a memory cell that has the electrical schematic of the cell of FIG. 1 and comprises a vertical trench for a capacitor and a superposed vertical transistor, in accordance with the present invention;
FIG. 3 is a top of a memory array using vertical transistors superposed over vertical trenches, in accordance with the present invention; and
FIGS. 4-11 show a portion of a silicon chip in various stages of the formation therein of a memory cell of the kind shown in FIG. 2 by one process in accordance with the present invention.

### Detailed Description

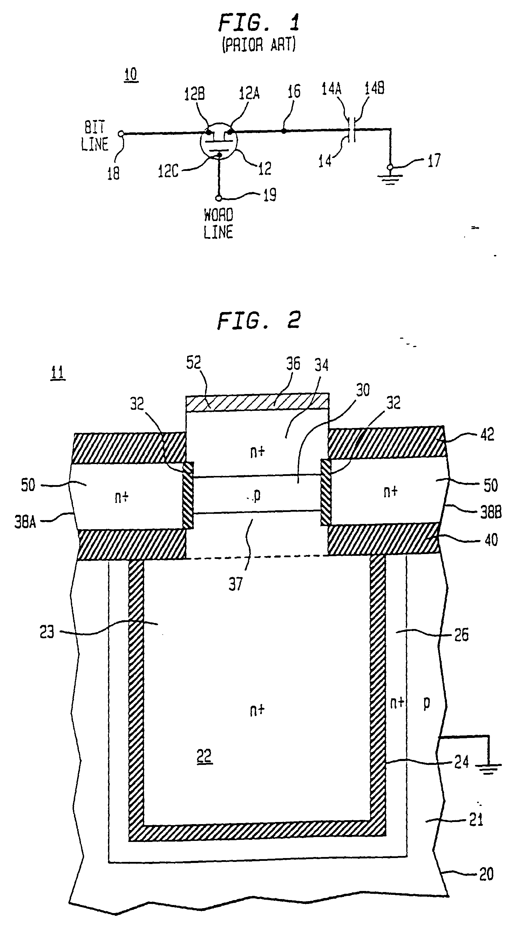

FIG. 1 shows an electrical circuit schematic of a memory cell 10. Such a cell is employed, for example, in a random access memory (RAM) integrated circuit (IC) or chip. Such a cell can also be used in a dynamic RAM (DRAM), a synchronous DRAM (SDRAM), or other memory chip. The cell includes a MOS transistor 12 in series with a capacitor 14. Transistor 12 has first and second output current electrodes 12A and 12B, respectively, and a gate electrode 12C. Gate electrode 12C of the switching transistor is connected to a word line of the DRAM array. Electrode 12A serves as the drain of the transistor when positive current flows therefrom through transistor 12 and into electrode 12B, which then serves the source. This occurs when logic information (data, signal bits, i.e., a "1" or a "0") is read into or refreshed into memory cell 10. Electrode 12B serves as the drain when information is read out of memory cell 12 as current flows from electrode 12B through transistor 12 to electrode 12A which serves as the source. However, as mentioned earlier, for simplicity, each will be described as a source/drain of transistor 12. Capacitor 14 has first (14A) and second (14B) plates. Plate 14B is typically coupled to a reference voltage, which is shown as ground 17 in the drawing. In some instances, it may be desirable to use some other reference voltage on plate 14B, such as Vpp/2. Transistor 12 is switched on to facilitate current flow from a bit line 18, which is connected to electrode 12A, to capacitor 14. It is switched off to isolate capacitor 14 from the bit line 18. A signal corresponding to a bit of information (logic information) is stored as charge on capacitor 14. When appropriate signals are applied to the word line 19 and to the bit line 18, data ("1" or a "0") is stored as charge on the capacitor 14 where it is held for a useful time. Because of leakage from storage node 16, it is generally necessary to refresh the stored data periodically.

FIG. 2 shows a structure of a memory cell 11 in accordance with the invention. A plurality of memory cells are interconnected to form an array or arrays. Such arrays are used to form memory integrated circuits such as DRAMs, synchronous DRAMs (SDRAMs), or other memory ICs. The memory cell 11 is shown formed in a portion of a semiconductive chip 20, such as a semiconductor wafer. The wafer comprises, for example, silicon. Other semiconductor wafers, including silicon on insulator (SOI) or gallium arsenide, are also useful. The wafer can be undoped or doped lightly or heavily with dopants having a first conductivity. In one embodiment, the chip includes a bulk portion that is advantageously a p-type monocrystalline silicon. Memory cell has the electrical schematic as that shown in FIG. 1. The chip 20, which includes a bulk monocrystalline portion 21, comprises a trench 22. In one embodiment, the trench includes a substantially square cross section filled with, for example, heavily doped n+ type polycrystalline silicon 23 that serves as the storage node 16 (FIG. 1) of memory cell 11. Trenches with other shaped cross section are also useful. The n+ polysilicon fill also corresponds to one plate 14A (FIG. 1) of the capacitor 14 merged with a source\drain 12B of the transistor 12.

A dielectric layer 24 surrounds the sidewalls and bottom of the trench 22 and serves as the dielectric of the capacitor 14. Optionally, a heavily doped n+ type layer 26 surrounds the outside of the trench 22 insulated from its fill 23 by the dielectric layer 24. Layer 26 serves as the other plate 114B (FIG. 1) of the capacitor 14. The p-type bulk 21 of the chip 20 typically is maintained at a reference potential, typically ground, as discussed above. Other reference potentials, such as Vpp/2, are also useful.

Located over the trench 22 is a vertical transistor that corresponds to transistor 12. The vertical MOSFET transistor includes n+ type layers 34 and 37, each generally circular in cross section, that correspond to source/drain 12B and source/drain 12A of FIG. 1 and so form the two output current terminals of the transistor. Intermediate between these extend the p-type layer 30 within which there will be created the n-type inversion layer (not shown) to serve as the conductive channel between the layers 34 and 37 when the gate voltage is such as to put the transistor in its closed switch conductive state. The gate dielectric of the transistor is provided by a silicon oxide layer 32 that surrounds layer 30. Layer 34 will merge with a conductive layer 36 that serves as a bit line 52 of the DRAM and runs over the surface of the trench in the direction normal to the plane of the drawing. Layer 37 corresponds to the storage node 16 (FIG. 1) of the memory cell 10.

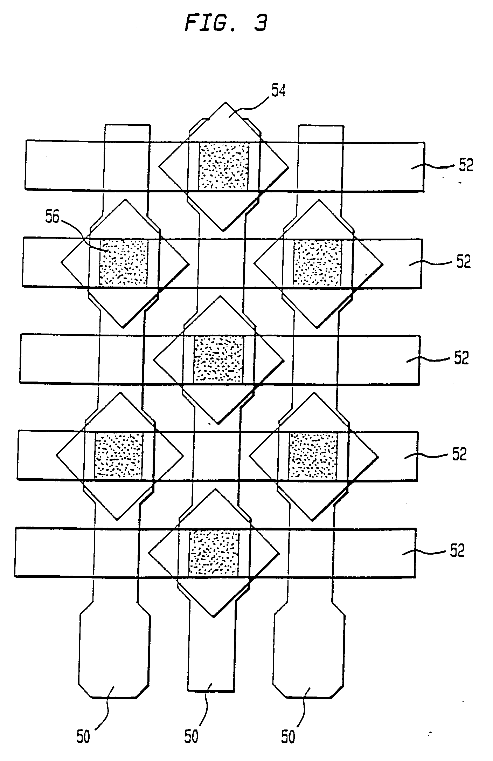

A word line 50 is provided by the segmented n+ type layer, shown as portions 38A, 38B, that also runs over the top surface of the chip 20 orthogonal to a bit line 36, as will appear from the discussion of FIG. 3 below. Layer portions 38A and 38B serve as the gate electrode 12C of transistor 12. The p+ type intermediate region 30 and the gate dielectric layer 32 essentially are stitched in between the two segments 38A and 38B of the word line 50. An oxide layer 40 insulates a bottom surface of the word line 50 from a top surface of the silicon chip 20.

It is desirable that the intermediate region 30 be of high mobility for the charge carriers, such as electrons in the NMOS-type transistor, because of its potential for higher switching speed. For this reason, it is desirable that the intermediate region comprises essentially monocrystalline. In accordance with one embodiment of the invention, a substantially monocrystalline intermediate region 30 is provided between the polycrystalline fill 23 of the trench 22 that serves as one source/drain 12A (FIG. 1) of the switching transistor and the silicon layer 34 over the region 30 that serves as the other source/drain 12B (FIG. 1) of the switching transistor. As shown, the intermediate region merges with the bit line 36 of the cell.

In FIG. 3, there is shown a top view of a two dimensional rectangular array of memory cells 11 of FIG. 2. As seen in FIG. 3, the columns of word lines 50 are running vertically, and the rows of bit lines 52 are running horizontally. Insulated crossovers are provided where the two sets of lines would otherwise intersect. The larger tilted squares 54 represent the outline of the vertical trenches 22, and the smaller squares 56 enclosed within the larger tilted square 54 are the outlines of the vertical transistors.

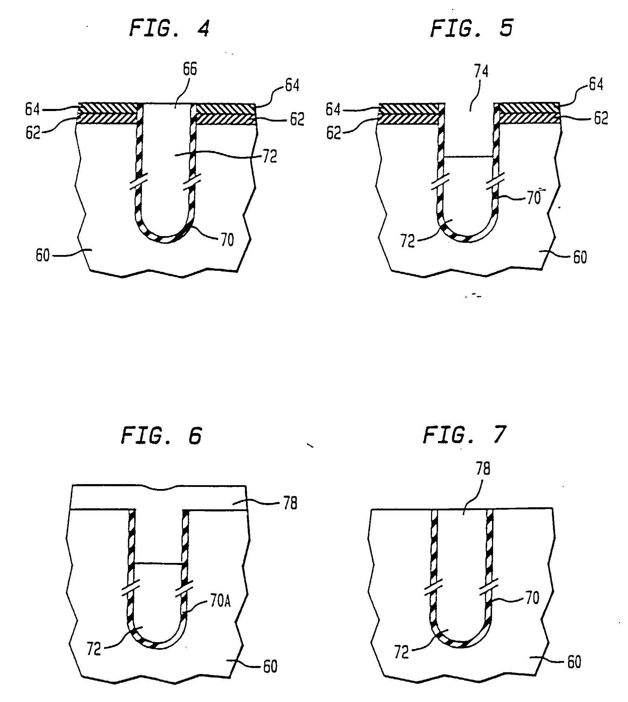

Referring to FIG. 4-10, the various steps for forming a memory cell in accordance with one embodiment are shown.

Typically a plurality of memory ICs are fabricated in parallel on a wafer. After the parallel processing, the wafer is subsequently diced into a number of chips. Each chip typically houses a single IC, each of which contain many thousands of cells and the associated auxiliary circuitry for writing in, reading out, and refreshing. For the sake of simplicity, the discussion of the processing will be limited to that involved with a single memory cell.

Typically, there is first formed a trench in a slice of a semiconductor substrate or wafer that serves as the workpiece 60. In one embodiment, the wafer comprises a silicon lightly doped with p-type dopants (p-). As is shown in FIG. 4, one typically begins by forming over the surface of a silicon workpiece (chip) 60, a thin layer 62 of silicon oxide, generally referred to as the PAD oxide. This layer primarily serves to protect the surface of the slice 60 during the processing and is removed in the course of the processing. The PAD oxide 62 is generally covered with a layer 64 of silicon nitride, generally described as the PAD nitride, that primarily-serves as an etch stop in some of the subsequent processing steps.

Next there is formed in the silicon workpiece 60 a trench 66 that will subsequently be filled with polysilicon. The polysilicon is heavily doped with n-typed dopants (n+) and serves as the storage node of the cell. This can be done in the usual fashion that requires providing a properly patterned mask over the surface of the slice and using anisotropic reactive ion etching (RIE) to form a trench in the silicon that has relatively straight side walls. Next, if a heavily doped plate region, as represented by n+ type layer 26 in FIG. 2, is to be included, which is optional, it would be formed by, for example, introducing a suitable dopant in the trench and diffusing it out into the substrate. There are a variety of techniques available to this end, as by coating the interior of the trench with an arsenic-rich coating and heating to diffuse the arsenic into the silicon wall of the trench for doping it n+ type. To simplify the drawing, this layer is being omitted in this and subsequent figures.

After the n+ type plate is formed, the walls of the trench 66 are treated to form a dielectric layer 70 there over that will serve as the dielectric of the capacitor. This preferably can be either of silicon oxide, silicon nitride, or silicon oxynitride.

Next, the trench is filled with n+ type doped polycrystalline silicon 72 (polysilicon). To get a good fill, the polysilicon is built up on a top surface of the workpiece 60 until the trench 22 is filled, as is shown in FIG. 4. After this the top surface is subjected to chemical mechanical polishing (CMP) to planarize the surface of the workpiece 60. In this operation, the silicon nitride layer 64 can serve as an etch stop to achieve planarization.

Reactive ion etching (RIE) is then used to etch a recess 74 in the polysilicon fill 72 in the trench 66. The RIE is selective to the pad nitride and dielectric layers. The results is shown in FIG. 5. Recess 74 imparts seed information for growing silicon thereon.

To this end, there are first stripped off the layers of the PAD silicon nitride 64 and PAD oxide 62 to bare the monocrystalline silicon surface of the workpiece 60. Then, an n+ type silicon layer 78 is grown epitaxially over the bared silicon surface of the workpiece. The epitaxially layer is sufficiently thick to fill the trench fill the trench with epitaxial silicon, which is typically essentially monocrystalline. Moreover, by heating the silicon to a suitable recrystallization temperature, typically above 1000°C, at least the top portion of the deposited silicon in the recess is monocrystalline with that deposited over the surrounding monocrystalline surface of the workpiece. Thus, the portion of the trench provides seed information for subsequent epitaxial growth that forms the regions of the transistor. The result is shown in FIG. 6. Then CMP is used to planarize the surface of the workpiece to about its original level before the epitaxial growth. The result is shown in FIG. 7.

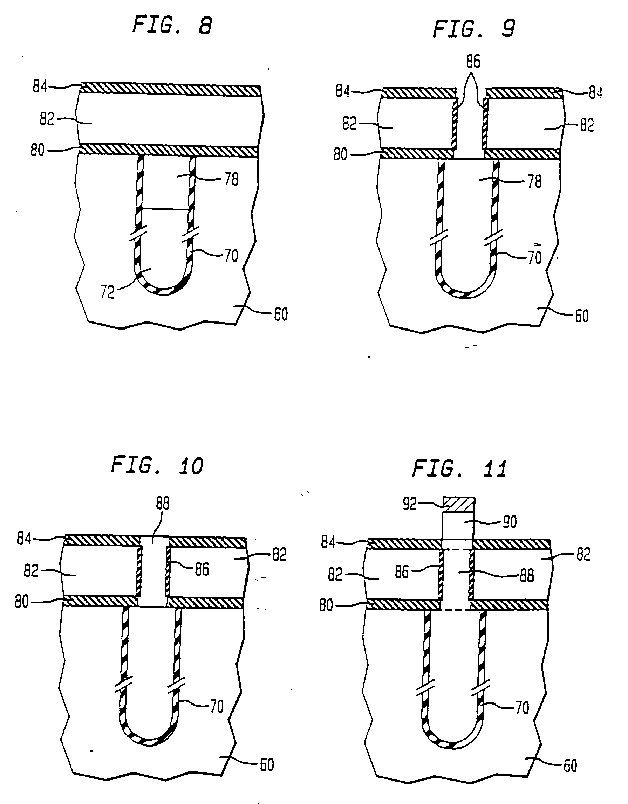

Next, as seen in FIG. 8, over the surface of the workpiece 60, a first layer of silicon oxide 80, a layer of n+ type doped polysilicon 82, and a second layer of silicon oxide 84 are formed in sequence. The polysilicon layer 82 serves as the word line of the cell.

Then there is etched an opening through both oxide layers 80 and 84 and the polysilicon layer 82 to about the level of the monocrystalline silicon that was formed at the top of the silicon fill 78 to get the result shown in FIG. 8.

There now is grown an oxide layer 86 over the exposed surface of the polysilicon layer 82 where it was etched through. This oxide layer is to serve as the gate oxide of the transistor and so should be grown appropriately. In one embodiment, this is done with a high pressure oxidation to insure a high quality layer suitable for use as the gate dielectric. The oxide layer, simultaneously formed over the top of silicon fill 78, is selectively removed to again bare the silicon surface. FIG. 9 shows the workpiece 60 including the gate oxide.

Now the opening is filled by the epitaxial growth of p+ type silicon 88 using the seed information provided by the essentially monocrystalline layer that had been formed at the top of the recess in the trench. To insure a good fill in the opening, the silicon is also deposited over the surface of the second oxide layer 84. Following this growth, by a heating step is employed to sufficiently foster recrystallization and so to improve the crystallinity of the silicon 88. It also serves to form a good channel interface with the underlying n+ type conductivity source/drain region.

This is then followed by CMP to planarize the surface by removing the excess silicon to the level of the second oxide layer 84 and results in a workpiece 60, as is shown in FIG. 10.

There remains to form the bit line over the newly formed monocrystalline silicon 88 to arrive at the structure shown in FIG. 2.

To this end n+ type polysilicon 90 is deposited over the surface of the workpiece 60 as shown in Fig. 11. Next, to increase the conductivity of this polysilicon that is to serve as the bit line, it is advantageous to coat it with a layer 92 typically of either tungsten, molybdenum, or titanium. This dual layer 90, 92 is then patterned in the usual fashion to extend selectively only over the polysilicon region 88. Furthermore, the alignment of the bit line to the transistor is relatively critical. It is generally advantageous to finish this off with an anneal to sinter the metal to the polysilicon to form the metal silicide and to diffuse dopants out of the polysilicon layer to form an n+ type source/drain region with the channel. The thickness of layer 82 and the annealing step can be used to adjust the drain/source overlap as desired.

There now results a cell that corresponds in essential details to the cell shown in FIG. 2.

It is to be understood that the specific embodiments described are merely illustrative of the general principles of the invention and various modifications will be possible without departing from the spirit and scope of the invention. For example, the monocrystalline silicon in which the memory cell is formed may be a layer of silicon that has been grown epitaxially on a suitable crystal of a foreign material, such as sapphire. Still further, the particular conductivity types can be reversed, and the conductivity of the various silicon layers varied as is known to workers in the art. Still further, the various processing steps involved, such as etching and depositions, may be varied. Furthermore, while the invention has been described in terms of silicon as the semiconductor, which presently is the preferred choice, other types of substrates are also useful. The scope of the invention should therefore be determined not with reference to the above description but with reference to the appended claims, along with their full scope of equivalents.

## Claims

1. A memory cell for use in an array of rows and columns of memory cells within a monocrystalline bulk portion of a silicon chip that are addressed by word lines and bit lines, said memory cell comprising:
a capacitor comprising a vertical trench filled with silicon and having a layer of dielectric along its wall that isolates the silicon fill from the bulk portion of the chip;
a vertical transistor superimposed over the trench and having a first source/drain merged with the silicon at the top of the trench, an intermediate silicon layer that is merged with the silicon fill at the top of the trench to form the first source/drain and in which an inversion layer is to be created to form a conductive channel, a second source/drain region overlying the intermediate silicon layer, a gate dielectric layer surrounding the intermediate silicon layer, a gate surrounding the gate dielectric layer and extending along the surface of the chip and dielectrically insulated therefrom and being coupled to a word line; and
a bit line in electrical contact with the second source/drain and otherwise extending over the surface of the trench and electrically insulated from the word line and from the chip.

2. The memory cell of claim 1 in which the word line is a layer of polysilicon.

3. The memory cell of claim 2 in which:
the silicon fill is polysilicon in the lower portion of the trench; and
the intermediate silicon layer is essentially monocrystalline silicon.

4. The memory cell of claim 1 in which the bulk portion of the chip is of a first conductivity type, the silicon fill of the trench is of a second conductivity type opposite said one type, the intermediate silicon layer is of said first conductivity type, and both source/drain regions are of the second conductivity type.

5. The memory cell of claim 4 in which there is included, around the outside of the dielectric layer that surrounds the polysilicon fill in the trench, a layer of the same conductivity type as that of the polysilicon fill for forming a rectifying junction with the bulk portion of the chip.

6. A process for making a memory cell comprising the steps of:
forming a trench in a silicon chip of one conductivity type;
forming a dielectric layer over the walls of the trench;
filling the trench with polysilicon of a conductivity type opposite that of the chip;
growing an epitaxial silicon layer over the surface of the chip of sufficient thickness for forming over the top of the trench a layer of essentially monocrystalline silicon of a conductivity that is opposite that of the chip for serving as a first source/drain;
forming a first dielectric layer over the surface of the chip;
forming a polysilicon layer of the conductivity type opposite that of the chip over the surface of the first dielectric layer;
forming a second dielectric layer over the surface of said polysilicon layer;
etching an opening through the first and second dielectric layers and said polysilicon layer to bare the essentially monocrystalline silicon over the top of the trench;
forming a silicon oxide layer selectively along the sidewall of the opening in the polysilicon layer;
growing monocrystalline silicon of the one conductivity type in the opening for forming an intermediate layer in which there will be formed the channel of a vertical transistor in which the silicon oxide layer over the sidewall of said polysilicon layer of the opening serves as the gate dielectric; and
depositing a conductive layer of the opposite conductivity type over the top surface of the chip that contacts the intermediate silicon layer for serving as a second source/drain and bit line of the cell.

7. The process of claim 6 in which before the step of forming the dielectric layer over the walls of the trench there is formed over the walls of the trench a layer of the conductivity type opposite that of the chip and after the formation of the dielectric layer the trench is filled with polycrystalline silicon of the conductivity type opposite that of the silicon chip.

8. A process for preparing a memory cell useful in memory that includes an array of memory cells arranged in rows and columns and accessed by word lines and bit lines, said process comprising the steps of:
forming a vertical trench in a monocrystalline silicon layer of a chip of one conductivity type;
forming a dielectric layer on the walls of the trench;
filling the trench with polycrystalline silicon of a conductivity type that is opposite that of the one conductivity type;
removing a top portion of the polysilicon fill in the trench;
growing silicon essentially epitaxially over the monocrystalline silicon surface of the chip and filling the trench with silicon of the opposite conductivity type for providing seed information in the silicon in the trench;
forming in turn over the silicon layer a first dielectric layer, an intermediate polysilicon layer of said one conductivity , and a second dielectric layer;
forming an opening through said first dielectric layer, said last mentioned polysilicon layer, and said second dielectric layer to the silicon layer at the top of the trench;
forming an oxide layer on the surface of the intermediate polysilicon layer exposed by said opening;
filling the opening with epitaxial silicon of the one conductivity type using the seed information of the silicon in the trench;
forming a layer of the opposite conductivity type over the last recited epitaxial silicon of the one conductivity type; and
forming a conductive layer over the last recited layer of the opposite conductivity type.

9. The process of claim 8 in which the polysilicon layer formed between said first and second dielectric layers is the word line of the cell, the last formed conductive layer over the silicon is the bit line of the cell and the epitaxial silicon of the one conductivity used to fill the opening serves as the layer of silicon in which there is created during operation the channel of a vertical transistor.

10. A process for preparing a memory cell, that has a transistor and a capacitor, for use in a memory that includes an array of memory cells arranged in rows and columns and accessed by word lines and bit lines, said process comprising the steps of:
forming a vertical trench in a monocrystalline silicon layer of one conductivity type;
forming a dielectric layer over the walls of the trench;
filling the trench with doped polysilicon of a conductivity type that is opposite that of the one conductivity type;
forming an epitaxial silicon layer of said opposite conductivity type over the top surface of the polysilicon layer for forming a monocrystalline layer in the top of the trench;
depositing in turn over the top surface of the chip a first layer of dielectric, an intermediate layer of polysilicon of the opposite conductivity type suitable for use as the word line, and a second layer of dielectric;
forming an opening through the first and second layers of dielectric and the intermediate layer of polysilicon to the monocrystalline layer at the top of the trench;
forming a gate oxide layer over the sidewalls of the opening through the intermediate polysilicon layer;
filling the opening with epitaxial silicon of the one conductivity type suitable for use as a layer in which there will be formed in operation the channel of the transistor of the memory cell and for forming a first source/drain interface with the underlying silicon of the transistor;
providing a second source/drain layer of the opposite conductivity type over said epitaxial layer of the one conductivity type; and
providing a conductive layer over the second drain/source layer for use as the bit line of the memory cell.
